# EUROPEAN PATENT SPECIFICATION

(11) **EP 2 081 228 B1**
(45) Date of publication and mention of the grant of the patent: **16.03.2011**
(21) Application number: 08150327.8
(22) Date of filing: 16.01.2008
(51) Int. Cl.: H01L 27/142, H01L 31/032, H01L 31/18, H01L 31/04

(54) **Photovoltaic Devices having Conductive Paths formed through the Active Photo Absorber**
Photovoltaikvorrichtungen mit Leiterbahnen, die durch den aktiven Photoabsorber gebildet werden
Dispositifs photovoltaïques dotés de chemins conducteurs formés dans le photoabsorbeur actif

(43) Date of publication of application: 22.07.2009
(73) Proprietor: Terra Solar Global, Inc., New York, NY 10111-2000 (US)
(72) Inventor: Li, Yuan-Min, New York, NY 10111-2000 (US)
(74) Representative: Wilhelms · Kilian & Partner Patentanwälte

(56) References cited:
- WO-A-2007/049384
- US-A- 5 798 284
- LINCOT D ET AL: "Chalcopyrite thin film solar cells by electrodeposition" SOLAR ENERGY, PERGAMON PRESS. OXFORD, GB, vol. 77, no. 6, 1 December 2004 (2004-12-01), pages 725-737, XP004661813 ISSN: 0038-092X

## Description

### FIELD OF THE INVENTION

This invention relates to large area photovoltaic (PV) solar devices and a method of making such devices.

### BACKGROUND OF THE INVENTION

The single cell voltage of most solar cells is too low to be directly usable or efficient for many applications. For example, the single cell voltage of a copper-indium-gallium-diselenide (CuInₓGa₁₋ₓSe₂, or CIGS for short) material ranges between 0.5 and 0.8 volts depending on the composition of the CIGS material (the absorber of the solar cell).

A great advantage of thin film photovoltaic (PV) processing technology, compared to traditional crystalline silicon wafer based PV module manufacturing processing, is the opportunity of monolithic integration of individual solar cells, on the same substrate used for the fabrication of solar cells over large areas, without resorting, to the cumbersome and laborious cell connections (in series and/or parallel) practiced in the industrial production of large area crystalline Si PV modules.

In manufacturing PV modules, single cells are connected in series to obtain a high voltage suitable for different applications. Typically, the output voltage of a PV module might range between 10 to 100 volts, depending on the number of cells interconnected in series,

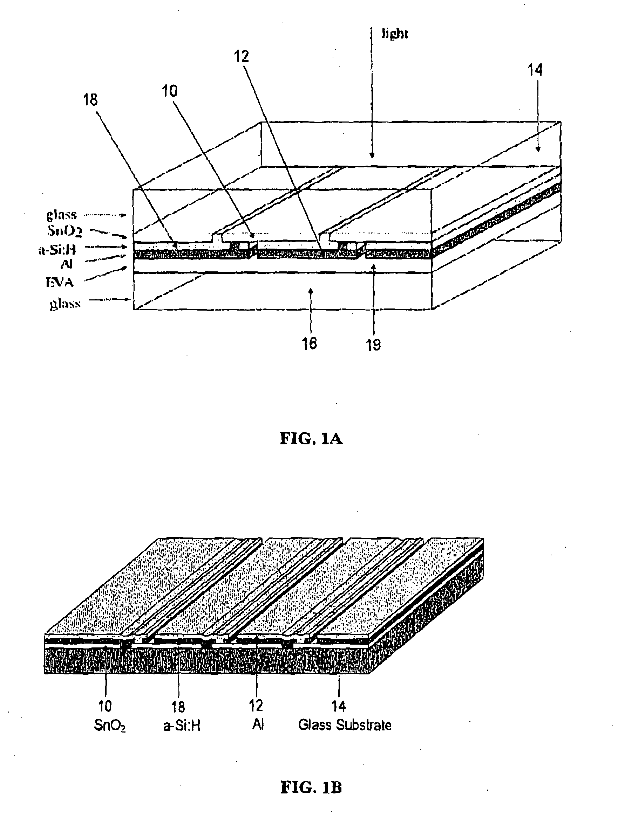

Figures 1A and 1B illustrate a conventional series interconnect scheme for an amorphous silicon (a-Si:H) PV module made by removal of semiconductor film to produce an array of individual series connected cells. The interconnection usually takes place in the manufacturing process by interconnecting a front transparent conductive layer 10 (front contact), e.g. tin oxide, of a first cell to a back conductive layer 12, e.g. aluminum, of an adjoining cell. These layers are encapsulated between two pieces of glass 14 and 16, respectively. The semiconductor Si film 18 (the *p-i-n* layers) which lies adjacent to and between the conductive layers 10 and 12 of the module is cut out by, e.g., laser scribe to expose the SnO₂ front contact 10, to allow the subsequently deposited back contact films of the *n+1*th cell to be directly in contact with the front contact of the adjacent nth cell. In this way the individual cells of the array are serially connected so as to increase the output voltage of the module. Typically, the module is sealed from the atmosphere by means of a sealant 19, such as ethylene vinyl acetate (EVA) which also bonds the front and back glass substrates 14 and 16.

Further amorphous silicon PC modules are described in US-A-5,798,284.

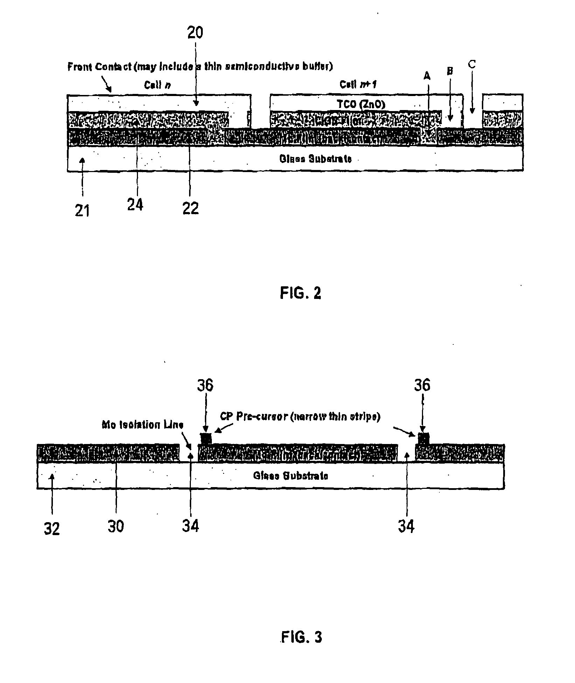

Another conventional device module employing CIGS PV films is shown in Figure 2. In these devices, where light falls on the device from the side opposite to a supporting plate 21, the aim is to connect a transparent conductive oxide (TCO), e.g. a zinc oxide (ZnO) front electrode 20 of the nth cell to the molybdenum (Mo) back electrode 22 of the n+1th cell. The series interconnection of individual cells usually takes place by using laser or mechanical processes whereby the different thin films and different cells are separated by removing a narrow line of the various thin film materials. In a conventional CIGS PV device of the structure glass/Mo/CIGS/buffer/ZnO, three scribing steps would take place, respectively at positions A, B, and C (see figure 2 for illustration), to create isolation lines in the Mo layer 22, CIGS film 24, and CIGS/buffer/ZnO layers 20. The first and the last scribing steps are needed to create individual (electrically separated) cells on the same substrate, while the 2^{nd} scribe (for the removal of the CIGS film to expose the Mo film) is the critical procedure to allow adjacent cells to be electrically connected in series (monolithic integration of solar cells).

Also, the ZnO front contact (and TCO thin films generally, including SnO₂ for a-Si based PV modules) is conventionally isolated by scribing techniques such as laser ablation and mechanical scratch. This method can damage the CIGS semiconductive thin films, and the material in the 'cut' grooves likely is inferior. Debris left in the isolation trenches often causes shorts that degrade the power output of such PV devices. The buffer indicated above (not shown in the figure) is an optional, but generally preferred layer. It may comprise a very thin film of high resistivity ZnO (HR ZnO) or an n-type semiconductor e.g. n-type CdS which forms a junction with the p-type CIGS absorber film. Other useful buffer materials include ZnS and CdZnS. Still others are mentioned in the later cited references. The buffer layer is deposited onto the light absorbing layer before deposition of the conductive ZnO. In the Figures described herein, for simplicity, the term TCO is meant to include ZnO as well as the stack of buffer layers and ZnO.

Further CIGS PV solar cells are described in WO 2007/049384.

For general discussion of these prior art techniques and their drawbacks with regard to mechanical and/or chemical removal of films for series interconnection, see e.g. US Patents Nos. 6459032 and 6380477. The traditional scribing method is taught in, e.g., US Patents Nos. 51.31954, 4892592 and 6288325. Also, in US Patent Nos. 4724011 & 4517403, there is described an alternative series interconnection scheme without the removal of the semiconductor thin film. These methods rely either on the shorting of the thin film (not a predictable or robust process) or some sort of post-deposition physical treatment using laser or local heating. Also there is a recent comprehensive review article by William N. Shafarman and Lars Stolt, "Cu(InGa)Se2 Solar Cells", page 567, Chapter 13, in "Handbook of Photovoltaic Science and Engineering", edited by Antonio Lugue and Steven Hegedus, John Wiley & Sons Ltd, England (2003). These references teach the methods known and used in the art for producing CIGS solar devices and the properties of these devices. As set forth in the latter reference , the term CIGS also includes a compound where some of the selenium may be replaced by sulfur.

In the case of CIGS semiconductor devices particularly, the removal of the material using a laser is not straight-forward. The material melts and it refills the trough (trench) formed by the laser ablation, not leaving a clean Mo surface necessary to make good electrical contact. Further, the presently used, conventional technique of mechanical scribe (relying on the sharp edge of a knife to cut through the layers) for CIGS film is not a robust process, as the quality of the scribe is too sensitive to many parameters, such as the morphology of the Mo film, the surface composition of the Mo film (MoSeₓ is formed during high temperature growth of CIGS), the properties of the CIGS film (including adhesion strength), and smoothness of the movement of the substrate relative to the tip of the knife, and pressure on the knife, etc. The interconnection between front ZnO and the back Mo often shows a large electrical resistance (poor contact). Also, removing the film often leads to excessive loss of the active area of the solar cell due to the need to maintain some margin of safety. Thus, a simpler, alternative method of producing high quality interconnection pathways between the front and back contacts is highly desirable.

In the case of a ZnO front contact, mechanical scribe for interconnect formation is slow, cumbersome, not terribly robust, and requires high capital investment in the equipment (e.g., highly precise movement of the scribe table to ensure consistency and accuracy of plate movement), and difficult to adjust the cut depth for optimal isolation quality without damaging the layers underneath. We have earlier pointed out the debris-induced shorting problem that usually accompanies the scribing technique.

### SUMMARY OF THE INVENTION

A solar PV module according to the invention comprises the feature combination of claim 1. Optional or preferred features are subject of dependent claims 2-4, respectively. The invention is also directed to a method of producing a solar PV module according to claim 5. Preferred method features are subject of dependent claims 6 to 17.

The novel structure of the present invention is achieved by substantially increasing the conductivity of the normally light absorbing PV film in the area of desired electrical contact without significantly affecting its thickness or lateral conformation to the flat substrate. Here, instead of removing strips of the active light absorbing film as presently practiced by PV module manufacturers, the interconnection is accomplished by leaving the film in place, but changing its conductivity so that an effective series interconnection is made from the 1^{st} electrode of one cell to the 2^{nd} electrode of the adjoining cell. The conductivity change is accomplished by incorporating in the light absorbing layer suitable dopants (or alloying elements) which greatly reduces the electrical resistance (resistivity) of the active semiconductor layer in the area of contact so as to make it essentially conductive in the doped areas.

### BRIEF DESCRIPTION OF THE DRAWINGS

Figures 1 and 1A are elevational views showing a prior art a-Si:H PV module array having serially connected PV solar cells.
Figure 2 shows a front elevational view of a prior art un-encapsulated CIGS PV plate having an array of serially connected solar cells.
Figs. 3-7 are front elevational views depicting one embodiment of a step by step formation of the solar PV module of the present invention wherein the conductive paths are formed using pre-CIGS deposited narrow dopant strips.
Figs. 8-13 are front elevational views depicting another embodiment of a step by step formation of the solar PV module of the present invention wherein the conductive paths are formed by means of narrow dopant strips applied to the surface of the active film subsequent to its formation followed by heating to diffuse the dopant into the CIGS film.

### DETAILED DESCRIPTION OF THE INVENTION

The invention will be described in terms of CIGS PV solar modules. However, it would be obvious to one in the art that light absorbing photovoltaic films other than CIGS can be employed in the practice of the present invention. Further, the term TCO as used herein shall comprise any suitable transparent conductive film including those which include buffer layers as taught, for example, in the cited Shafarman & Stolt reference.

Generally, in accordance with the invention, a solar electric module comprises an array of serially interconnected thin film PV solar cells formed on a substrate. Each cell of the array comprises a back electrode spaced from the back electrode of the adjoining cell, a light absorbing PV film in contact with the back electrode of one cell and extending over at least a portion of the back electrode of the adjoining cell, a TCO front electrode over the PV film, a small portion of which overlies a small portion of the back electrode of the adjoining cell, the TCO front electrodes and the back electrodes of each cell being spaced from the front and back electrodes respectively of the adjoining cells and wherein the normally highly electrically resistive PV film lying between the TCO layer of one cell and the back electrode of the adjoining cell has been modified so as to form a conductive series interconnection between the adjoining cells.

A primary aspect of the present invention is the fact that the CIGS film may be left in place after its deposition but its conductivity in the areas of cell interconnection is changed so that an effective interconnection is made between the 1^{st} electrode (e.g. ZnO transparent electrode) and the adjoining cell's 2^{nd} electrode (e.g. Mo electrode). The conductivity change can be accomplished by incorporating one or more suitable dopants or alloying elements in the CIGS film in the interconnect region. Typically, the dopant(s) change the sheet resistance of the CIGS film from ~10⁵ Ohm/Square (Ω/□) to under 1Ω /□. Potential dopants for reducing the sheet resistance in CIGS films are metals e.g. Cu, Ag, In, Au, Tl, Ga, K and Cs and their compounds such as the selenides, tellurides, sulfides and iodides. Generally, it is more difficult to control and limit the lateral diffusion of metallic dopants as compared with dopants such as Cu₂Se and thus control the width of the interconnect, lines of the array. The amount of dopant to be employed i.e. the thickness of the dopant layer and its width is dependent on the thickness of the CIGS absorbing layer.

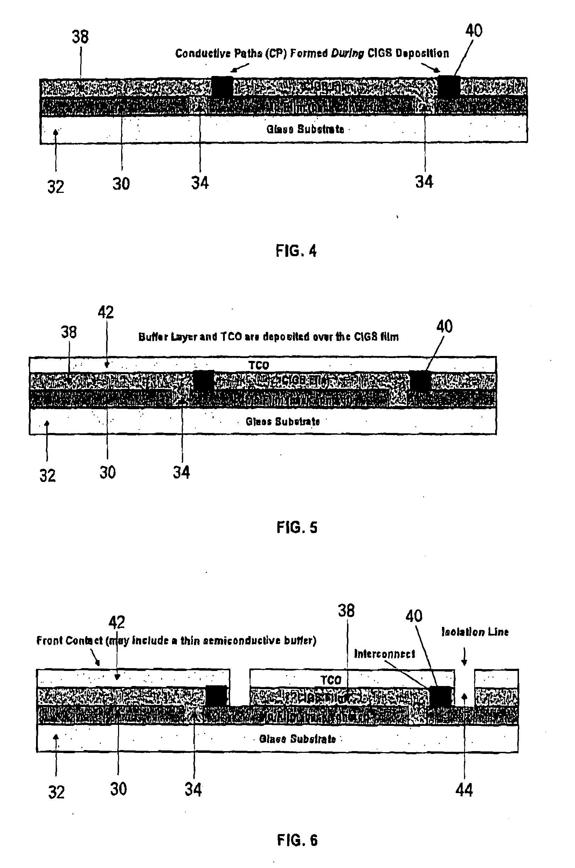

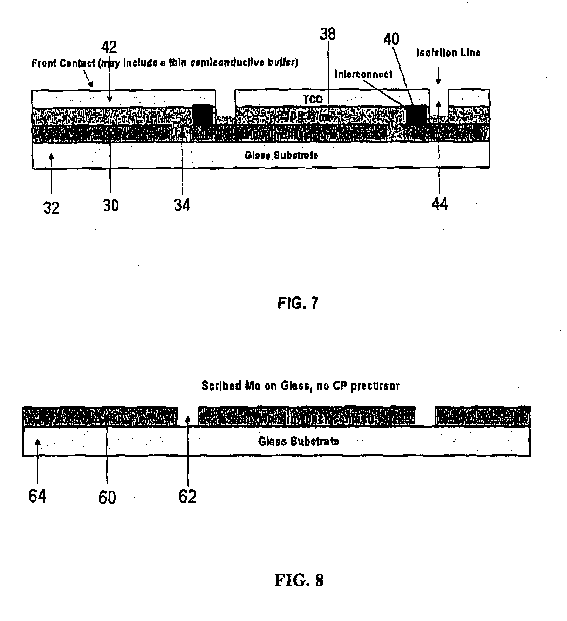

As an example, for a 1.5 micron thick CIGS film, a narrow strip of dopant compound having a thickness of about 0.5 microns should be adequate to form the low resistance inter-connect pathway. When narrow strips of a Cu₂Se dopant layer are deposited prior to CIGS formation, no further heat treatment is required after formation of the CIGS layer since at the temperature (typically 500°C - 600°C) of formation of the CIGS, the dopant readily diffuses into the CIGS to form the low resistance inter-connect with only slight broadening of the narrow dopant line. However, when the dopant layer is deposited over an existing CIGS layer, the array must be heat treated to diffuse the dopant into the CIGS layer to form the conductive path. Heating at about 300°C for 1/2 hour is adequate. Two embodiments of this invention are illustrated in connection with the drawings. In the first embodiment (Figs.3-7), a patterned molybdenum film 30 which acts as the back electrodes of the module is formed on a substrate 32, e.g. glass. The space 34 between adjacent Mo films forms cell isolation lines. A thin, narrow strip of 'dopant' material 36 is deposited on the Mo films 30 adjacent the Mo isolation lines 34. Suitable dopants include, but are not limited to Cu₂Se, Cu₂S, and silver-containing alloys. Upon deposition of a continuous CIGS film 38, the dopant 36 diffuses into the CIGS film 38 to form a local, conductive path 40 comprising doped or alloyed CIGS. No specific post-deposition treatment is needed for this process to occur as the conductive paths are formed as part of the natural procedure during formation the CIGS semiconductor film 38. This is the preferred method of embodiment of this invention. Subsequent to deposition of the CIGS film, a transparent conductive electrode layer 42 (with or without buffer films), e.g. ZnO or CdS/HR ZnO/ZnO is formed over the array. TCO cell isolation lines 44 are then provided through the TCO layer. As long as the isolation lines 44 extend through the TCO layer 42, they may or may not also extend through or partially through the CIGS film 38. (Compare Figs. 6 and 7). The conductive interconnects form a series connection between adjacent cells in the array.

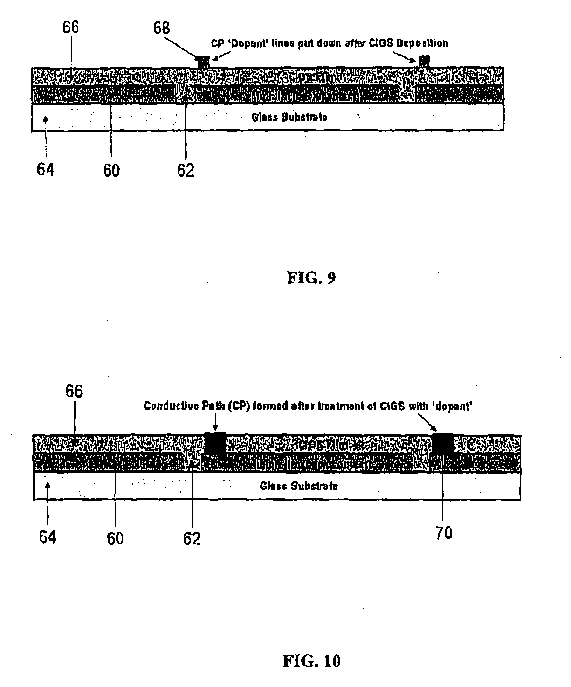

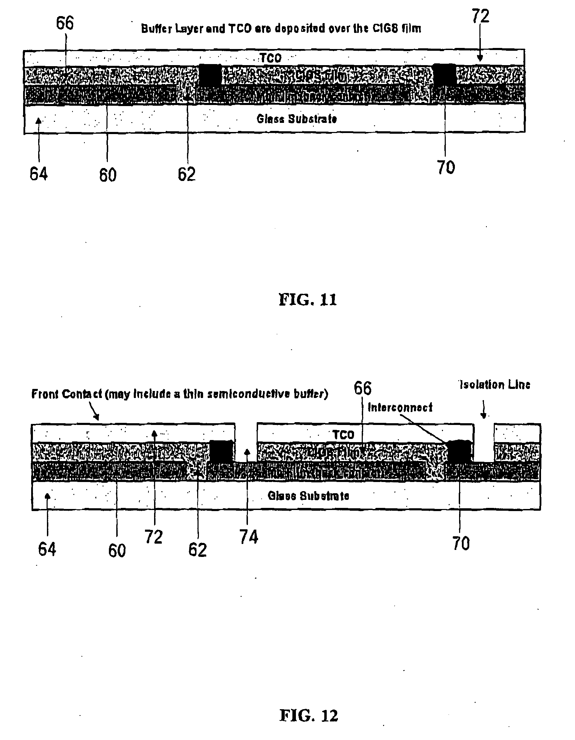

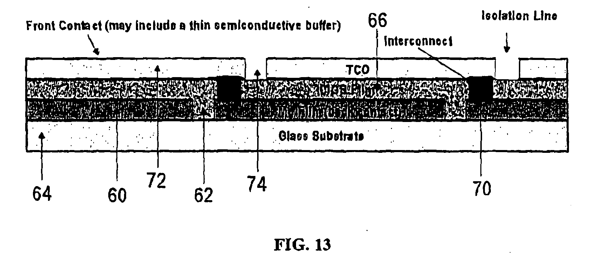

Figs. 8-13 illustrate a second embodiment for formation of the novel PV module of the present invention. In accordance with this embodiment, a post-deposition modification of the conductivity of the CIGS film at desired locations is accomplished. Here, Mo back electrodes 60 separated by Mo isolation lines 62 are provided on a glass substrate 64. A continuous CIGS film 66 is deposited over the array as is well known in the art. Subsequent to CIGS film 66 formation, narrow dopant lines 68 are deposited on the CIGS film 66 over the Mo electrodes 60 adjacent the Mo isolation lines 62. Subsequent treatment of the sample (heat or laser or thermal-pressure) results in the diffusion of the dopants into the CIGS host to produce narrow, high-conductivity interconnection paths 70 at the desired locations. A TCO film 72 is the deposited over the CIGS film 66. Isolation lines 74 are then formed in the TCO film 72 so as to provide the front electrodes 72 of the cells of the array. The TCO electrode 72 of one cell makes good electrical contact with the Mo back electrode 60 of the adjoining cell either with or without removing any CIGS film. As previously indicated, the TCO film can be a conductive oxide e.g. ZnO or ZnSnO and may incorporate a thin buffer layer e.g. HR ZnO and/or CdS. Further, during isolation of the front electrodes, all some or none of the underlying CIGS film is removed.

In both of the aforementioned embodiments care should be taken so that there is no substantial lateral diffusion of the dopant that would result in unnecessarily widening the interconnect conductive line and creating dead areas in the otherwise active CIGS material.

Any of the methods well known in the art can be used to deposit materials in their desired locations. These include: screen printing, laser heating, defining the line with a printing head, evaporation through a mask, etc. Further, if the TCO layers are deposited through a mask such that the TCO layer of each cell is isolated from the TCO layer of adjoining cells, no subsequent isolation step would be required and the CIGS layer (including the conductive strips) could remain as a continuous layer.

## Claims

1. A solar PV module comprising an array of serially interconnected PV solar cells on a common substrate (32), each cell comprising a front electrode (42) and a back electrode (30) spaced from said front electrode (42), a light absorbing PV film (38) between said front (42) and back (30) electrodes, said front elecirrode (42) being light transmitting, wherein the front electrode (42) of an nth solar cell of the array overlies and is connected to the back electrode (30) of a succeeding (n+1)th cell of the array via a portion of said PV film which has been modified to have a substantially higher conductivity than the remainder of the PV film, and wherein the high conductivity portion of the PV film (38) is formed by doping a continuous PV film along spaced narrow strips (40) where the front electrode (42) of the nth cell overlies the back electrode (30) of the succeeding (n+1)th cell, and wherein the light absorbing PV film is a CIGS layer.

2. The PV module recited in claim 1, wherein the dopant is copper selenide.

3. The PV module recited in claim 1, wherein the TCO layer includes at least one thin buffer.

4. The PV module recited in claim 3, wherein the back electrode is molybdenum, the TCO layer comprises zinc oxide and the conductive interconnect dopant comprises copper selenide, the module further comprising a glass cover plate and a sealant.

5. A method of producing a solar PV module which comprises an array of serially interconnected solar cells comprising the steps of depositing a continuous light absorbing, high resistance, PV CIGS layer (38) over a substrate (32) having spaced 1^{st} electrodes (30) thereon and doping said PV CIGS layer along narrow conductive strips (40) with a doping agent that forms a conductive path through said PV CIGS layer (38) along said strips (40) followed by forming spaced 2^{nd} electrodes (42) over said PV CIGS layer (38) having said conductive strips so as to provide a serial interconnection between said first electrode (30) of one cell in the array and the 2^{nd} electrode (42) of an adjoining cell.

6. The method recited in claim 5, wherein a narrow strip of dopant is applied adjacent an edge of the spaced 1^{st} electrodes of the array prior to depositing the light absorbing PV CIGS film whereby the conductive strips in said film are formed during deposition of said PV CIGS film.

7. The method recited in claim 6, wherein the dopant is a member of the group selected from Cu, Ag, In, TI, Ga, K, Cs and their respective selenides; tellurides, sulfides and iodides.

8. The method recited in claim 7, wherein the dopant is copper selenide.

9. The method recited in claim 8, wherein the 1^{st} electrodes of the array are molybdenum films on a glass substrate and the 2^{nd} electrodes of the array are TCO thin films.

10. The method recited in claim 9, wherein the TCO layer comprises ZnO and a buffer layer.

11. The method recited in claim 5, wherein the resistant, continuous, fight absorbing PV CIGS film is deposited over said 1^{st} electrodes and the spaces therebetween and narrow strips of dopant are thereafter deposited over said PV CIGS film and the array is then heat treated to cause the dopant to diffuse into said PV CIGS film so as to create said narrow conductive paths therein.

12. The method recited in claim 11, wherein the dopant is a member of the group selected from Cu, Ag, In, Ti, Ga, K, Cs and their respective selenides, tellurides, sulfides and iodides.

13. The method recited in claim 12, wherein the dopant is copper selenide.

14. The method recited in claim 13, wherein the 1^{st} electrodes of the array are molybdenum films on a glass substrate and the 2^{nd} electrodes of the array are TCO electrodes.

15. The method recited in claim 14, wherein the TCO layer comprises ZnO and a buffer layer.

16. The method recited in claim 15, wherein the buffer layer comprises copper sulfide.

17. The method recited in claim 10, wherein the buffer layer comprises copper sulfide.

## Patentansprüche

1. PV-Solarmodul, umfassend eine Gruppe seriell verbundener PV-Solarzellen auf einem gemeinsamen Substrat (32), wobei jede Zelle eine vorderseitige Elektrode (42) und eine rückseitige Elektrode (30), die von der vorderseitigen Elektrode (42) beabstandet ist, einen lichtabsorbierenden PV-Film (38) zwischen der vorderseitigen (42) und der rückseitigen (30) Elektrode aufweist, und wobei die vorderseitige Elektrode (42) einer n-ten Solarzelle der Gruppe die rückseitige Elektrode (30) einer nachfolgenden (n+1)-ten Zelle der Gruppe überlagert und mit dieser verbunden ist durch einen Abschnitt des PV-Films, der derart modifiziert worden ist, dass er eine im Wesentlichen höhere Leitfähigkeit hat als der übrige Teil des PV-Films, und wobei der hochleitfähige Abschnitt des PV-Films (38) durch Dotieren eines kontinuierlichen PV-Films entlang beabstandeter schmaler Streifen (40) gebildet ist, und wobei die vorderseitige Elektrode (42) der n-ten Zelle die rückseitige Elektrode (30) der nachfolgenden (n+1)-ten Zelle überlagert, und wobei der lichtabsorbierende PV-Film eine CIGS-Schicht ist.

2. PV-Modul nach Anspruch 1, wobei die Dotiersubstanz Kupferselenid ist.

3. PV-Modul nach Anspruch 1, wobei die TCO-Schicht zumindest einen dünnen Puffer umfasst.

4. PV-Modul nach Anspruch 3, wobei die rückseitige Elektrode aus Molybdän ist, die TCO-Schicht Zinkoxid aufweiset und die leitfähige verbindende Dotiersubstanz Kuperselenid umfasst, und wobei das Modul des weiteren eine Glasabdeckplatte und eine Dichtung aufweist.

5. Verfahren zum Herstellen eines PV-Solarmoduls, das eine Gruppe seriell verbundener Solarzelle aufweist, mit den Schritten des Abscheidens einer kontinuierlichen lichtabsorbierenden, hochohmigen PV-CIGS-Schicht (38) auf einem Substrat (32), das zueinander beabstandete erste Elektroden (30) darauf aufweist, und des Dotierens der PV-CIGS-Schicht entlang schmaler leitfähiger Streifen (40) mit einer Dotiersubstanz, die eine leitfähigen Bahn durch die PV-CIGS-Schicht (38) entlang der Streifen (40) bildet, des anschließenden Bilden beabstandeter zweiter Elektroden (42) auf der PV-CIGS-Schicht (38), welche die leitfähigen Streifen aufweist, um so eine serielle Verbindung zwischen der ersten Elektrode (30) einer Zelle in der Gruppe und der zweiten Elektrode (42) einer benachbarten Zelle vorzusehen.

6. Verfahren nach Anspruch 5, wobei ein schmaler Streifen der Dotiersubstanz benachbart einem Rand der beabstandeten ersten Elektroden der Gruppe aufgebracht wird, bevor der lichtabsorbierende PV-CIGS-Film abgeschieden wird, wodurch die leitfähigen Streifen in dem Film während des Abscheidens des PV-CIGS-Films gebildet werden.

7. Verfahren nach Anspruch 6, wobei die Dotiersubstanz aus der Gruppe Cu, Ag, In, TI, Ga, K, Cs und ihrer jeweiligen Selenide, Telluride, Sulfide und Jodide ausgewählt ist.

8. Verfahren nach Anspruch 7, wobei die Dotiersubstanz Kupferselenid ist.

9. Verfahren nach Anspruch 8, wobei die ersten Elektroden der Gruppe Molybdänfilme auf einem Glassubstrat und die zweiten Elektroden der Gruppe TCO-Dünnfilme sind.

10. Verfahren nach Anspruch 9, wobei die TCO-Schicht ZnO und eine Pufferschicht aufweist.

11. Verfahren nach Anspruch 5, wobei der hochohmig, kontinuierliche, lichtabsorbierende PV-CIGS-Film auf den ersten Elektroden und den Abständen dazwischen abgeschieden wird, und schmale Streifen der Dotiersubstanz im Anschluss auf den PV-CIGS-Film abgeschieden werden, und die Gruppe danach wärmebehandelt wird, so dass die Dotiersubstanz in den PV-CIGS-Film diffundieren kann, um so die schmalen leitfähigen Bahnen darin zu erzeugen.

12. Verfahren nach Anspruch 11, wobei die Dotiersubstanz aus der Gruppe Cu, Ag, In, Tl, Ga, K, Cs und ihrer jeweiligen Selenide, Telluride, Sulfide und Jodide ausgewählt ist.

13. Verfahren nach Anspruch 12, wobei die Dotiersubstanz Kupferselenid ist.

14. Verfahren nach Anspruch 13, wobei die ersten Elektroden der Gruppe Molybdänfilme auf einem Glassubstrat und die zweiten Elektroden der Gruppe TCO-Elektroden sind.

15. Verfahren nach Anspruch 14, wobei die TCO-Schicht ZnO und eine Pufferschicht aufweist.

16. Verfahren nach Anspruch 15, wobei die Pufferschicht Kupfersulfid aufweiset.

17. Verfahren nach Anspruch 10, wobei die Pufferschicht Kupfersulfid aufweist.

## Revendications

1. Module PV solaire comprenant un réseau de cellules solaires PV interconnectées en série sur un substrat commun (32), chaque cellule comprenant une électrode avant (42) et une électrode arrière (30) espacée de ladite électrode avant (42), un film PV absorbant la lumière (38) entre lesdites électrodes avant (42) et arrière (30), ladite électrode avant (42) transmettant la lumière, où l'électrode avant (42) d'une n^{ième} cellule solaire du réseau recouvre l'électrode arrière (30) d'une (n+1)^{ième} cellule suivante du réseau et est connectée à celle-ci, via une portion dudit film PV qui a été modifiée pour avoir une conductivité sensiblement supérieure au reste du film PV, et où la portion de conductivité élevée du film PV (38) est formée par dopage d'un film PV continu le long de bandes étroites espacées (40) où l'électrode avant (42) de la n^{ième} cellule recouvre l'électrode arrière (30) de la (n+1)^{ième} cellule suivante, et où le film PV absorbant la lumière est une couche CIGS.

2. Module PV selon la revendication 1, dans lequel le dopant est le séléniure de cuivre.

3. Module PV selon la revendication 1, dans lequel la couche TCO inclut au moins un tampon mince.

4. Module PV selon la revendication 3, dans lequel l'électrode arrière est en molybdène, la couche TCO comprend de l'oxyde de zinc et le dopant d'interconnexion conducteur comprend du séléniure de cuivre, le module comprenant en outre une plaque de couverture en verre et un produit d'étanchéité.

5. Méthode de production d'un module PV solaire qui comprend un réseau de cellules solaires interconnectées en série comprenant les étapes consistant à déposer une couche CIGS PV continue de résistance élevée et absorbant la lumière (38) sur un substrat (32) sur lequel se trouvent des premières électrodes (30) espacées et à doper ladite couche CIGS PV le long de bandes conductrices étroites (40) avec un agent dopant qui forme un chemin conducteur à travers ladite couche CIGS PV (38) le long desdites bandes (40), puis à former des secondes électrodes (42) espacées sur ladite couche CIGS PV (38) ayant lesdites bandes conductrices de sorte à former une interconnexion en série entre ladite première électrode (30) d'une cellule dans le réseau et la seconde électrode (42) d'une cellule attenante.

6. Méthode selon la revendication 5, dans laquelle une bande étroite de dopant est appliquée à côté d'un bord des premières électrodes espacées du réseau avant le dépôt du film CIGS PV absorbant la lumière, moyennant quoi les bandes conductrices dans ledit film sont formées pendant le dépôt dudit film CIGS PV.

7. Méthode selon la revendication 6, dans laquelle le dopant est un élément du groupe choisi parmi Cu, Ag, In, Tl, Ga, K, Cs et leurs séléniures, tellurures, sulfures et iodures respectifs.

8. Méthode selon la revendication 7, dans laquelle le dopant est le séléniure de cuivre.

9. Méthode selon la revendication 8, dans laquelle les premières électrodes du réseau sont des films en molybdène sur un substrat en verre et les secondes électrodes du réseau sont des films minces TCO.

10. Méthode selon la revendication 9, dans laquelle la couche TCO comprend du ZnO et une couche tampon.

11. Méthode selon la revendication 5, dans laquelle le film CIGS PV continu, résistant et absorbant la lumière est déposé sur lesdites premières électrodes et les espaces entre elles et des bandes étroites de dopant sont ensuite déposées sur ledit film CIGS PV et le réseau est alors traité thermiquement pour provoquer une diffusion du dopant dans ledit film CIGS PV de façon à créer lesdits chemins conducteurs étroits dans celui-ci.

12. Méthode selon la revendication 11, dans laquelle le dopant est un élément du groupe choisi parmi Cu, Ag, In, Tl, Ga, K, Cs et leurs séléniures, tellurures, sulfures et iodures respectifs.

13. Méthode selon la revendication 12, dans laquelle le dopant est le séléniure de cuivre.

14. Méthode selon la revendication 13, dans laquelle les premières électrodes du réseau sont des films en molybdène sur un substrat en verre et les secondes électrodes du réseau sont des électrodes TCO.

15. Méthode selon la revendication 14, dans laquelle la couche TCO comprend du ZnO et une couche tampon,

16. Méthode selon la revendication 15, dans laquelle la couche tampon comprend du sulfure de cuivre.

17. Méthode selon la revendication 10, dans laquelle la couche tampon comprend du sulfure de cuivre.
